(19) **Europäisches Patentamt**

**European Patent Office**

**Office européen des brevets**

(11) **EP 1 400 020 B1**

(12) **EUROPÄISCHE PATENTSCHRIFT**

(45) Veröffentlichungstag und Bekanntmachung des Hinweises auf die Patenterteilung:
**31.08.2005 Patentblatt 2005/35**

(51) Int Cl.7: **H03M 1/00**

(21) Anmeldenummer: **02730636.4**

(86) Internationale Anmeldenummer:
**PCT/IB2002/002240**

(22) Anmeldetag: **18.06.2002**

(87) Internationale Veröffentlichungsnummer:
**WO 2002/103914 (27.12.2002 Gazette 2002/52)**

(54) **INTEGRIERENDER A/D-WANDLER**

INTEGRATING A/D CONVERTER

CONVERTISSEUR A/N INTEGRE

(84) Benannte Vertragsstaaten:
**AT BE CH CY DE DK ES FI FR GB GR IE IT LI LU MC NL PT SE TR**

(30) Priorität: **18.06.2001 DE 10128942**

(43) Veröffentlichungstag der Anmeldung:
**24.03.2004 Patentblatt 2004/13**

(73) Patentinhaber: **Mettler-Toledo GmbH**
**8606 Greifensee (CH)**

(72) Erfinder: **REICHMUTH, Arthur**
**CH-8620 Wetzikon (CH)**

(56) Entgegenhaltungen:
**DE-A- 3 642 495          DE-A- 4 220 408**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen integrierenden, insbesondere nach dem sogenannten "Charge Balancing" Verfahren arbeitenden A/D-Wandler nach dem Oberbegriff des Patentanspruchs 1.

Zur Wandlung von in Messvorrichtungen auftretenden analogen Signalen in dazu korrespondierende digitale Signale werden vorzugsweise integrierende A/D-Wandler eingesetzt, die kostengünstig hergestellt werden können und die eine hohe Auflösung aufweisen.

Ein integrierender A/D-Wandler ist beispielsweise in einer Kraftmessvorrichtung einsetzbar, wie sie in [1], der EP-A-0 990 880 beschrieben ist. Darin wird ein in einer Sollposition ruhender, mit einer Kompensationsspule versehener Hebel durch Einwirkung einer zu messenden Kraft ausgelenkt, die durch Erzeugung eines auf fest montierte Permanentmagnete einwirkenden Magnetfeldes kompensiert wird, so dass der Hebel wieder in die Sollposition zurückgeführt wird. Das auf die Permanentmagnete einwirkende Magnetfeld wird mittels der Kompensationsspule aufgebaut, in die ein zur Kompensation der zu messenden Kraft erforderlicher Strom eingeleitet wird. Der Wert des Kompensationsstroms, der vorzugsweise mittels eines integrierenden A/D-Wandlers digital darstellbar ist, stellt somit ein Mass für die zu messende Kraft dar.

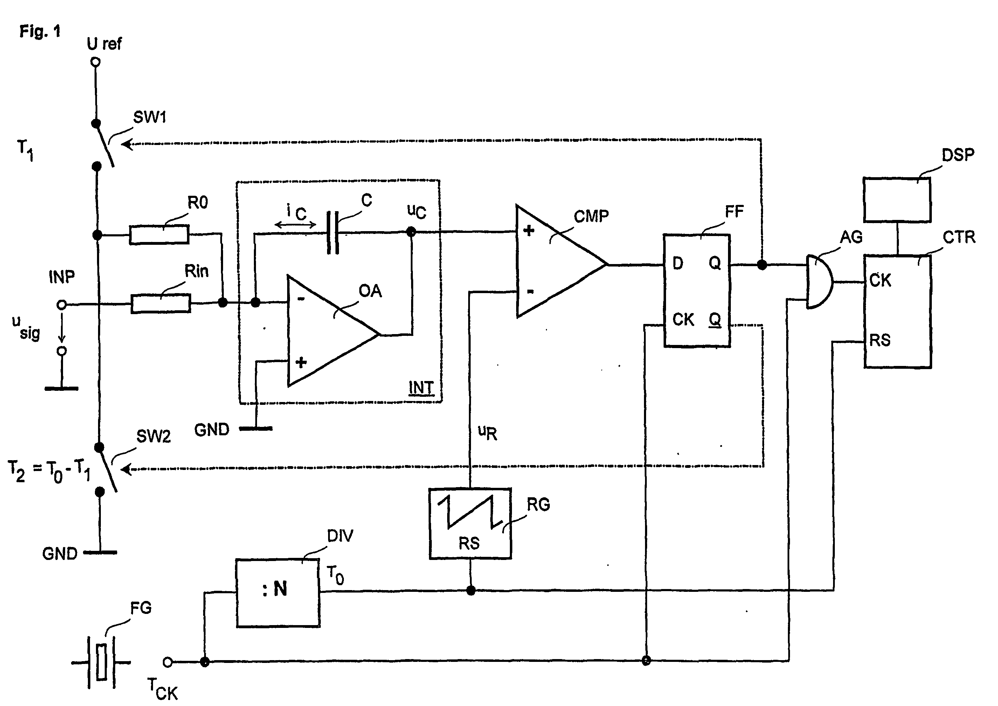

Bekannte integrierende A/D-Wandler, die beispielsweise in [2], Richard C. Dorf, Electrical Engineering Handbook, zweite Ausgabe, CRC Press, Boca Raton 1997 auf Seite 846 oder in [3], der US-A-4,164,733 beschrieben sind, arbeiten beispielsweise nach dem sogenannten "Dual Slope" Verfahren oder nach dem "Charge Balancing" Verfahren, das nachstehend anhand von Figur 1 näher erläutert wird.

Bei integrierenden A/D-Wandlern wird ein analoges Eingangssignal integriert, wodurch ein vorgesehener integrierender Kondensator eine entsprechende Ladungsänderung erfährt. Zur Kompensation dieser vom Eingangssignal abhängigen Ladungsänderung wird dem Integrator periodisch ein Referenzsignal zugeführt, mittels welchem die Ladungsänderung kompensiert wird. Die Dauer, während der die Kompensation der Ladungsänderung erfolgt, kann daher als Mass für die Grösse des Eingangssignals verwendet werden.

Ein derartiger ladungsbalancierender A/D-Wandler ist in Figur 1 dargestellt. Dieser A/D-Wandler weist einen Integrator INT mit einem Operationsverstärker OA auf, dessen Ausgang über einen Kondensator C mit dessen invertierendem Eingang verbunden ist, dem über einen Eingangswiderstand $R_{in}$ eine an einen Signaleingang INP angelegte negative Eingangsspannung $u_{sig}$ und über einen Referenzwiderstand R0 eine Referenzspannung $U_{ref}$ zuführbar ist. Während der Eingangswiderstand $R_{in}$ permanent mit der Eingangsspannung beaufschlagt ist, ist der Referenzwiderstand R0 entweder über einen ersten Schalter SW1 mit der Referenzspannung $U_{ref}$ oder über einen zweiten Schalter SW2 mit Erdpotential GND verbunden.

Der Ausgang des Operationsverstärkers OA, an dem die Spannung $u_C$ anliegt, ist mit dem nicht-invertierenden Eingang eines Komparators CMP verbunden, dessen invertierender Eingang am Ausgang eines Rampengenerators RG anliegt, dessen Ausgangssignal innerhalb von Arbeitsperioden T0, die mittels einer Teilungsstufe DIV aus Taktimpulsen $T_{CK}$ eines Taktgenerators FG abgeleitet sind, periodisch zurückgesetzt wird.

Der Ausgang des Komparators CMP ist mit dem Signaleingang D einer Kippstufe FF, beispielsweise eines D-Flip-Flops verbunden, deren Takteingang CK mit Taktimpulsen $T_{CK}$ beaufschlagt ist und deren nicht-invertierender Ausgang Q den ersten Schalter SW1 und deren invertierender Ausgang $\underline{Q}$ den zweiten Schalter SW2 steuert.

Der nicht-invertierende Ausgang Q der Kippstufe FF ist ferner mit dem ersten Eingang eines UND-Tors AG verbunden, dessen zweiter Eingang mit Taktimpulsen $T_{CK}$ beaufschlagt ist und dessen Ausgang mit dem Takteingang CK eines Zählers CTR verbunden ist, dem daher jeweils Taktimpulse $T_{CK}$ zugeführt werden, wenn die Kippstufe FF gesetzt ist. Der Zähler CTR, dessen Reset-Eingang RS mit dem Ausgang der Teilungsstufe DIV verbunden ist, und der daher nach jeder Arbeitsperiode T0 zurückgesetzt wird, ist mit einer Anzeigeeinheit DSP verbunden, die den während jeder Arbeitsperiode T0 erreichten Zählerstand jeweils anzeigt.

Mögliche in der Schaltungsanordnung von Figur 1 auftretende Signalverläufe sind in Figur 2 und Figur 3 gezeigt. Die Angaben auf der Ordinate sind zur Vereinfachung der Beschreibung normiert.

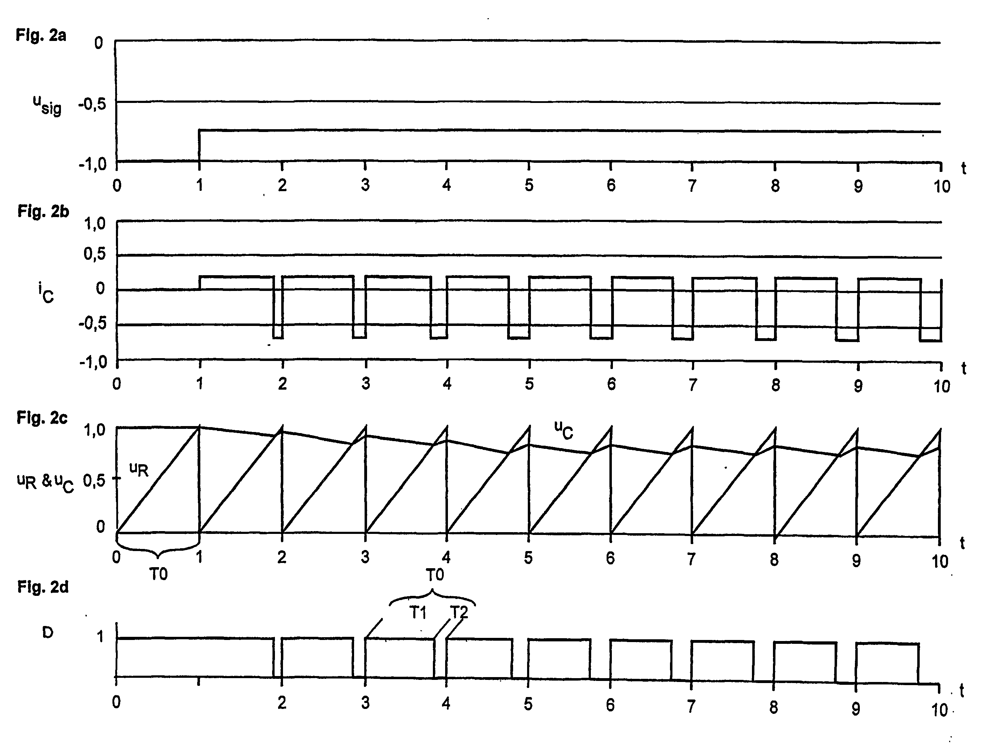

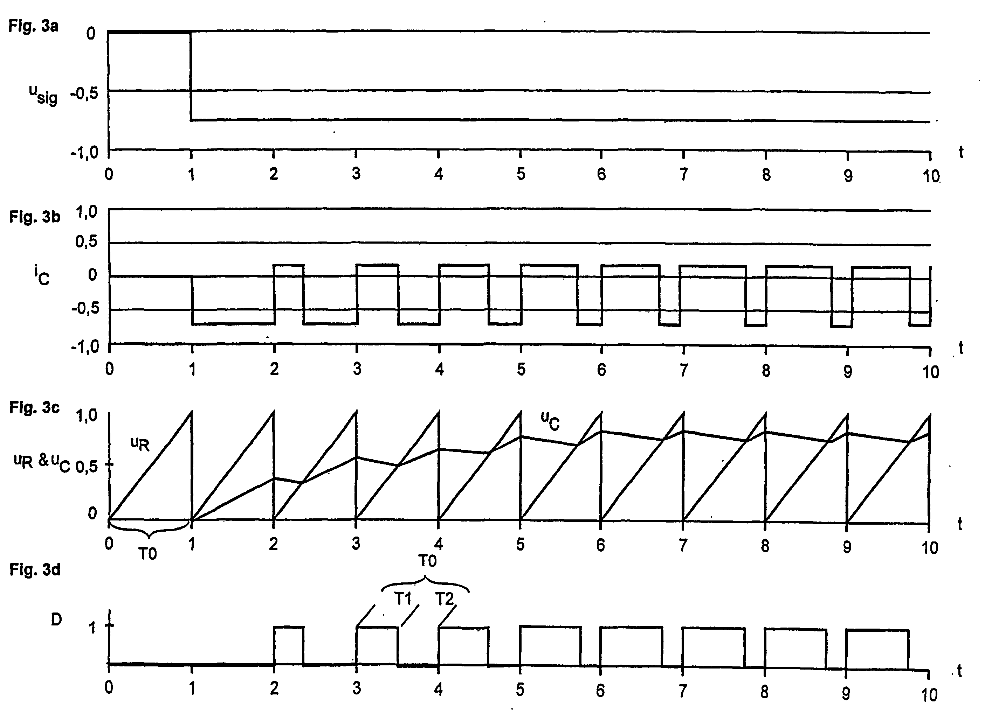

In Figur 2 wird der Ausgleich der den Kondensator C ladenden Ströme ausgehend von einem zum Zeitpunkt t=1 geladenen Kondensator C und in Figur 3 wird der Ausgleich der den Kondensator C ladenden Ströme ausgehend von einem zum Zeitpunkt t=1 entladenen Kondensator C gezeigt, wobei zum Zeitpunkt t=1 in beiden Figuren 2 und 3 die Eingangsspannung $u_{sig}$ auf den Wert -0,7 gesetzt ist.

Figur 2a und Figur 3a zeigen den Verlauf der Eingangsspannung $u_{sig}$, zu der ein Strom im Eingangswiderstand $R_{in}$ korrespondiert, welch letzterer mit dem invertierenden Eingang des Operationsverstärkers OA verbunden ist.

In Figur 2 liegt die Eingangsspannung $u_{sig}$ vor dem Zeitpunkt t=1 bei -1,0. Der Kondensator C ist geladen und die Spannung $u_C$ am Ausgang des Operationsverstärkers OA liegt daher über der vom Rampengenerator RG abgegebenen Spannung $u_R$, weshalb am Signaleingang der Kippstufe FF der Wert logisch Eins anliegt, der mit einem Taktimpuls $T_{CK}$ zum Ausgang Q und invertiert zum Ausgang $\underline{Q}$ durchgeschaltet wird. Der erste Schalter SW1 ist daher geschlossen, während der zweite Schalter SW2 geöffnet bleibt.

Am mit dem invertierenden Eingang des Operationsverstärkers OA verbundenen Anschluss des Kondensators C resultiert die Summe der durch den Eingangswiderstand $R_{in}$ und den Referenzwiderstand R0 fliessenden Ströme. Aufgrund der Polarität der Eingangsspannung $u_{sig}$ wird der vom Eingangswiderstand $R_{in}$ geführte Strom vom Strom subtrahiert, der im Referenzwiderstand R0 geführt wird. Mittels dieses in Figur 2b und Figur 3b gezeigten Summenstroms $i_C$ wird der Kondensator C in Anteilen T1 der Arbeitsperiode T0, in denen die Kippstufe FF gesetzt ist, entladen.

Die Periodenanteile T1, in denen die Kippstufe FF gesetzt ist (Q=1), sind in den Figuren 2d und 3d gezeigt. Die dazu korrespondierenden Signalverläufe der Spannung $u_C$ am Kondensator C sind in den Figuren 2c und 3c dargestellt. Dabei sind die Effekte der Diskretisierung durch den Takt $T_{CK}$ der Einfachheit halber weg gelassen.

Sobald die vom Rampengenerator RG abgegebene Spannung $u_R$ die Spannung $u_C$ am Ausgang des Operationsverstärkers OA überschreitet, resultiert am Signaleingang der Kippstufe FF der Wert logisch Null, wonach die zurückgesetzte Kippstufe FF den Schalter SW1 öffnet und den Schalter SW2 schliesst, so dass während einem zweiten Periodenanteil T2 der Summenstrom $i_C$ anschliessend dem Strom durch den Eingangswiderstand $R_{in}$ entspricht, durch den der Kondensator C wieder geladen wird.

Aus Figur 3c ist ersichtlich, dass der Kondensator C bei diesem Beispiel zum Zeitpunkt t=1 vollständig entladen ist. In der ersten Arbeitsperiode, zwischen den Zeitpunkten t=1 und t=2 liegt die Rampenspannung daher durchgehend über der Ausgangsspannung $u_C$ des zweiten Operationsverstärkers OA2, so dass die Kippstufe FF während der gesamten Arbeitsperiode T0 zurückgesetzt bleibt und daher keine Kompensation mittels der Referenzspannung $U_{ref}$ erfolgt.

Da in Figur 2 und Figur 3 zum Zeitpunkt t1 dieselbe Eingangsspannung $u_{sig}$ angelegt wird, resultiert nach mehreren Arbeitsperioden T0 eine gleiche Aufteilung der Arbeitsperiode T0 in einen ersten Periodenanteil T1 und einen zweiten Periodenanteil T2, in denen die jeweils zu- und weggeführten Ladungen ausbalanciert sind. Die Länge des Periodenanteils T1 und somit die Anzahl der innerhalb des Periodenanteils T1 verstreichenden Takte $T_{CK}$ ist daher proportional zur Grösse des Eingangssignals $u_{sig}$. Die Grösse des Eingangssignals $u_{sig}$ kann anhand der Anzahl der registrierten Takte $T_{CK}$ daher digital dargestellt werden.

In der Schaltungsanordnung von Figur 1 werden zu Beginn des Periodenanteils T1 mit dem Setzen der Kippstufe FF die Takte $T_{CK}$ über das UND-Tor AG zum Zähler CTR durchgeschaltet, bis die Kippstufe FF nach Abschluss des Periodenanteils T1 wieder zurück gesetzt wird. Der Zähler CTR zählt daher die Takte $T_{CK}$ innerhalb des Periodenanteils T1, leitet das Ergebnis beispielsweise nach Abschluss der betreffenden Arbeitsperiode T0 an eine Anzeigeeinheit DSP weiter und wird gleichzeitig wieder zurückgesetzt, um die Takte $T_{CK}$ innerhalb des nächsten Periodenanteils T1 zählen zu können. Das Eingangsignal wird ständig dem Integrator zugeführt. Nur die Referenzspannung wird geschaltet. Für eine im zeitlichen Mittel konstante Spannung $u_C$ am Ausgang des Integrators entspricht daher der negative Mittelwert der geschalteten Referenzspannung exakt dem Eingangssignal. Da jedoch die Kippstufe nur zu diskreten Zeitpunkten des Takts $T_{CK}$ umschalten kann, ist der Periodenanteil T1 auch bei konstantem Eingangssignal $u_{sig}$ im allgemeinen nur bis auf eine Zähleinheit konstant und der exakte Wert ergibt sich aus dem Mittel der gezählten Takte über eine grössere Zahl von Arbeitsperioden T0. Mit einer geeigneten Auswerteschaltung, auf die hier einzugehen sich erübrigt, lässt sich der Wert entsprechend genau ermitteln und zur Anzeige bringen.

Mit der Schaltungsanordnung von Figur 1 können Werte des Eingangssignals $u_{sig}$ mit umgekehrter, d.h. positiver Polarität hingegen nicht gemessen werden, da ein entsprechender im Eingangswiderstand $R_{in}$ fliessender Strom aufgrund der Polarität der Referenzspannung $U_{ref}$ nicht kompensiert werden kann. Der Arbeitsbereich der Schaltungsanordnung ist daher auf Eingangssignale $u_{sig}$ negativer Polarität begrenzt.

Zur Kompensation von Ladungsverschiebungen bipolarer Eingangssignale $u_{sig}$ könnte zusätzlich eine zweite Referenzspannung umgekehrter Polarität verwendet werden, wodurch jedoch, nebst zusätzlichem Schaltungsaufwand, weitere Fehlermöglichkeiten resultieren würden.

Mit jeder Änderung des Eingangssignals $u_{sig}$ ändert in der beschriebenen Schaltungsanordnung ferner auch der Kompensationsstrom, der dem Kondensator C durch den Referenzwiderstand R0 zugeführt wird. Dies hat zur Folge, dass die in diesem Widerstand freigesetzte Verlustwärme ändert. Dies kann eine Änderung des Wertes des Referenzwiderstandes R0 aufgrund resultierender Temperaturänderungen zur Folge haben, wodurch Messfehler entstehen. Bei konstanter Referenzspannung $U_{ref}$ und z.B. leicht erhöhtem Wert des Referenzwiderstandes R0 müsste der Periodenanteil T1, während dessen der Ladungsausgleich erfolgt, leicht ansteigen, womit der ermittelte digitale Wert des Eingangssignals $u_{sig}$ über dem tatsächlichen Wert liegen würde, und umgekehrt.

Ferner ist aus der DE 36 42 495 C2 ein A/D-Wandler für elektromechanische Waagen bekannt, bei dem der invertierende Eingang eines Operationsverstärkers über einen Widerstand an einen Anschlusspunkt einer vier Dehnungsmessstreifen aufweisenden Messbrücke angeschlossen ist und zusätzlich auch noch über einen zusätzlichen Widerstand und einen Schalter mit einem negativen Pol einer Referenzspannung verbunden werden kann.

Der vorliegenden Erfindung liegt daher die Aufgabe zugrunde, einen integrierenden, insbesondere nach dem "Charge Balancing" Verfahren arbeitenden A/D-Wandler zu schaffen, der zur Verarbeitung bipolarer Eingangssignale geeignet ist und gleichzeitig eine erhöhte Stabilität aufweist.

Diese Aufgabe wird mit einer Vorrichtung gelöst, welche die in Anspruch 1 angegebenen Merkmale aufweist.

Vorteilhafte Ausgestaltungen der Erfindung sind in weiteren Ansprüchen angegeben.

Der integrierende A/D-Wandler weist einen Operationsverstärker auf, dessen Ausgang und dessen invertierender Eingang über einen Kondensator miteinander verbunden sind, welchem über einen Signaleingang und einen an eine Referenzspannung angeschlossenen Referenzwiderstand während Anteilen einer Arbeitsperiode Ladungen zuführbar und wieder entnehmbar sind, die durch Änderung der Periodenanteile balancierbar sind. Die Messung der Anzahl Takte eines Taktsignals innerhalb eines der Periodenanteile ergibt daher für jede Arbeitsperiode ein digital darstellbares Mass für die Grösse des an den Eingangswiderstand angelegten Eingangssignals.

Erfindungsgemäss ist der nicht-invertierende Eingang des Operationsverstärkers über einen ersten Widerstand an die Referenzspannung angeschlossen und über einen zweiten Widerstand mit Erdpotential verbunden. Der Referenzwiderstand wird mittels eines Schalters während des ersten Periodenanteils mit der Referenzspannung und während des zweiten Periodenanteils mit Erdpotential verbunden.

Der integrierende A/D-Wandler erlaubt somit die Verarbeitung von, bezogen auf das Potential an den Eingängen des Operationsverstärkers, bipolaren Eingangssignalen. Da der nicht-invertierende Eingang des Operationsverstärkers durch den ersten Widerstand und den zweiten Widerstand auf ein erhöhtes Spannungspotential gesetzt ist, ist zudem gewährleistet, dass der Referenzwiderstand während jedes Periodenanteils von Strom durchflossen wird, so dass eine Stabilisierung der Verlustleistung und somit auch des Widerstandswertes des Referenzwiderstandes erzielt wird.

Vorzugsweise sind der erste Widerstand und der zweite Widerstand von gleicher Grösse, so dass der absolute Betrag der Spannung über dem Referenzwiderstand während des ersten und des zweiten Periodenanteils immer gleich gross ist. Die Verlustleistungen des Referenzwiderstandes während der beiden Periodenanteile sind daher ebenfalls gleich gross, so dass die mittlere Verlustleistung des Referenzwiderstandes unabhängig von der Grösse des Eingangssignals und den daraus resultierenden Grössenverhältnissen der beiden Periodenanteile immer konstant ist. Störende, durch Verlustleistungsschwankungen verursachte Messfehler werden somit vermieden.

Die beschriebenen Massnahmen tragen zu einer deutlichen Verbesserung des Betriebsverhaltens des A/D-Wandlers bei, da die Stabilität des Referenzwiderstandes für die Genauigkeit der ermittelten digitalen Werte von besonderer Bedeutung ist.

Der Aufwand zur Stabilisierung der Temperatur des Referenzwiderstandes kann daher reduziert werden.

In einer vorzugsweisen Ausgestaltung der Erfindung wird eine Stromquelle, deren Ströme zu messen sind, mit dem invertierenden Eingang des Operationsverstärkers verbunden.

In einer weiteren vorzugsweisen Ausgestaltung der Erfindung ist der Referenzwiderstand in zwei Referenzteilwiderstände aufgeteilt, die einerseits mit dem invertierenden Eingang des Operationsverstärkers verbunden sind und von denen mittels eines Schalters der erste Referenzteilwiderstand während des ersten Periodenanteils mit der Referenzspannung und während des zweiten Periodenanteils mit Erdpotential und von denen der zweite Referenzteilwiderstand während des ersten Periodenanteils mit Erdpotential und während des zweiten Periodenanteils mit der Referenzspannung verbunden ist. Die Referenzteilwiderstände sind thermisch gekoppelt und weisen zumindest annähernd den gleichen Widerstandswert auf.

Bei dieser Ausgestaltung der Erfindung können der erste und der zweite Widerstand, die einen Spannungsteiler bilden, an den der nicht-invertierende Eingang des Operationsverstärkers angeschlossen ist, entsprechend einem beliebig wählbaren Bereich festgelegt werden, innerhalb dessen Eingangssignale unterschiedlicher Polarität verarbeitet werden können. Die Summe der Verlustleistungen in den beiden Referenzteilwiderständen bleibt unabhängig von den Eingangssignalen konstant, so dass die Referenzteilwiderstände, zwischen denen ein Wärmeaustausch stattfindet, stets dieselbe Temperatur aufweisen. Fehler, die von den Referenzwiderständen verursacht werden könnten, werden bei dieser Ausgestaltung der Erfindung daher auch dann vermieden, wenn der Bereich bipolarer Eingangssignale beliebig gewählt wird.

In einer weiteren vorzugsweisen Ausgestaltung werden zwei Referenzwiderstände verwendet, die einerseits mit dem invertierenden Eingang des Operationsverstärkers verbunden sind und von denen mittels eines Schalters der erste Referenzwiderstand während eines ersten Periodenanteils mit der Referenzspannung und der zweite Referenzwiderstand während eines zweiten Periodenanteils mit Erdpotential verbindbar ist. Bei dieser Ausgestaltung der Erfindung werden auf einfache Weise möglicherweise auftretende und schädliche Kurzschlussströme während des Umschaltens vermieden.

Der erfindungsgemässe A/D-Wandler, der eine präzise Wandlung der Eingangssignale gewährleistet und kostengünstig herstellbar ist, kann in verschiedenen Messvorrichtungen vorteilhaft eingesetzt werden. Besonders vorteilhaft ist der Einsatz des A/D-Wandlers in einer Kraftmessvorrichtung, in der mittels einer Stromquelle ein zu messender Strom erzeugt wird.

Nachfolgend wird die Erfindung anhand von Zeichnungen näher erläutert. Dabei zeigt:

Fig. 1    einen integrierenden A/D-Wandler, der zur Verarbeitung unipolarer Eingangssignale geeignet ist,

Fig. 2    den Verlauf verschiedener Signale im A/D-Wandler von Figur 1 nach Änderung des Eingangssignals ausgehend von einem negativen Maximalwert,

Fig. 3    den Verlauf verschiedener Signale im A/D-Wandler von Figur 1 nach Änderung des Eingangssignals ausgehend von einem Minimalwert,

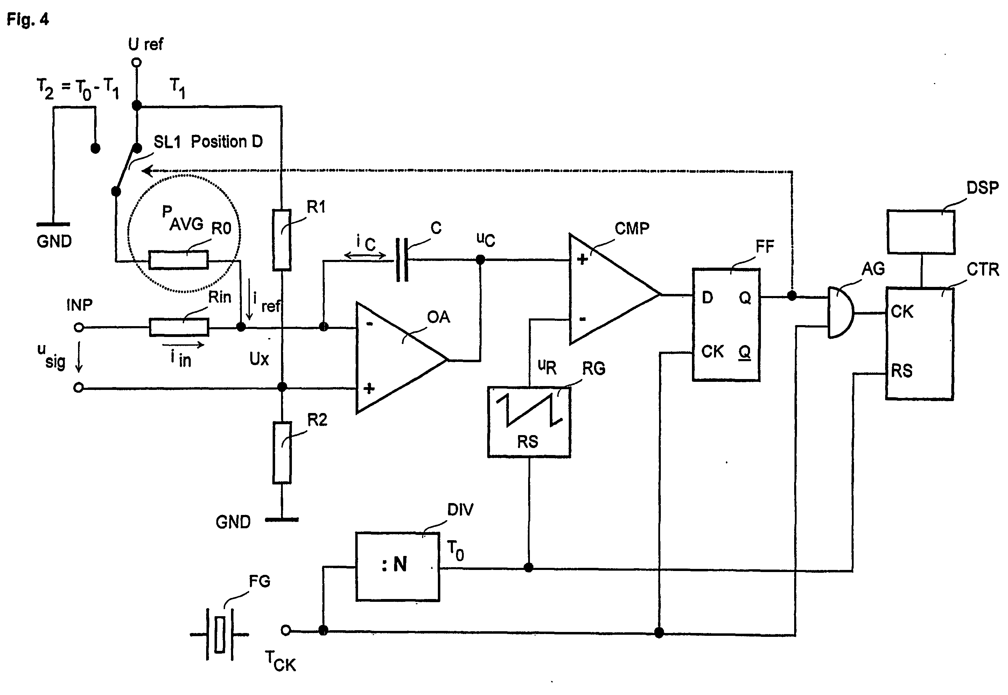

Fig. 4    einen integrierenden A/D-Wandler, der zur Verarbeitung bipolarer Eingangssignale geeignet ist,

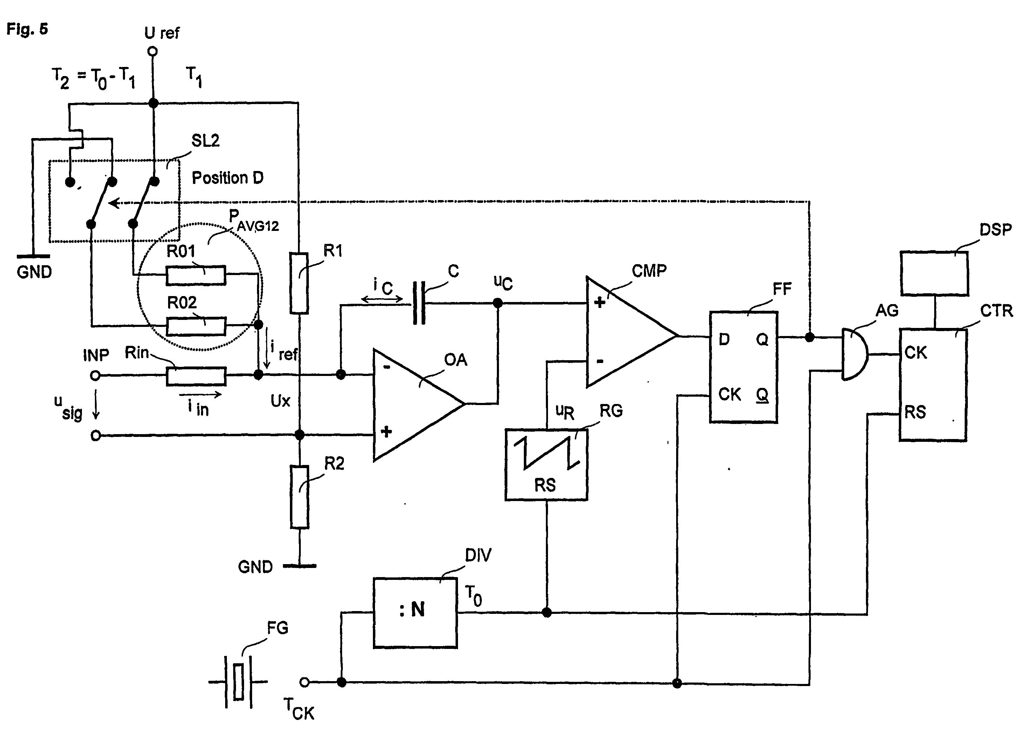

Fig. 5    einen integrierenden A/D-Wandler mit beliebig wählbarem Arbeitsbereich für die Verarbeitung bipolarer Eingangssignale,

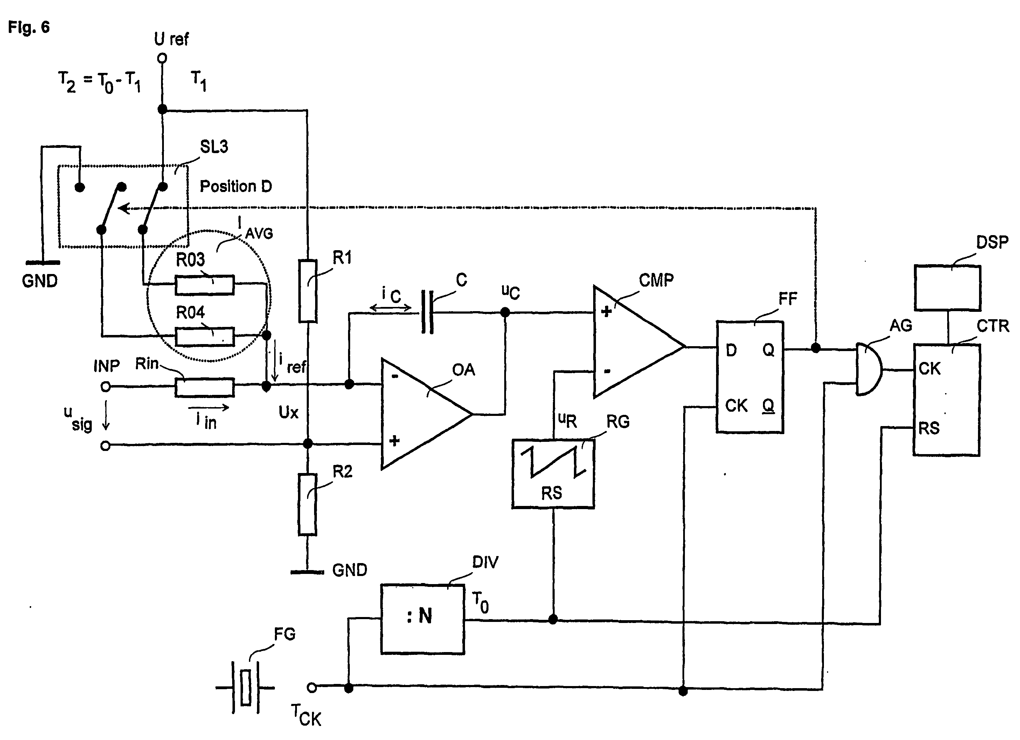

Fig. 6    einen integrierenden A/D-Wandler für die Verarbeitung bipolarer Eingangssignale, bei dem möglicherweise auftretende Kurzschlussströme während des Betriebs vermieden werden und

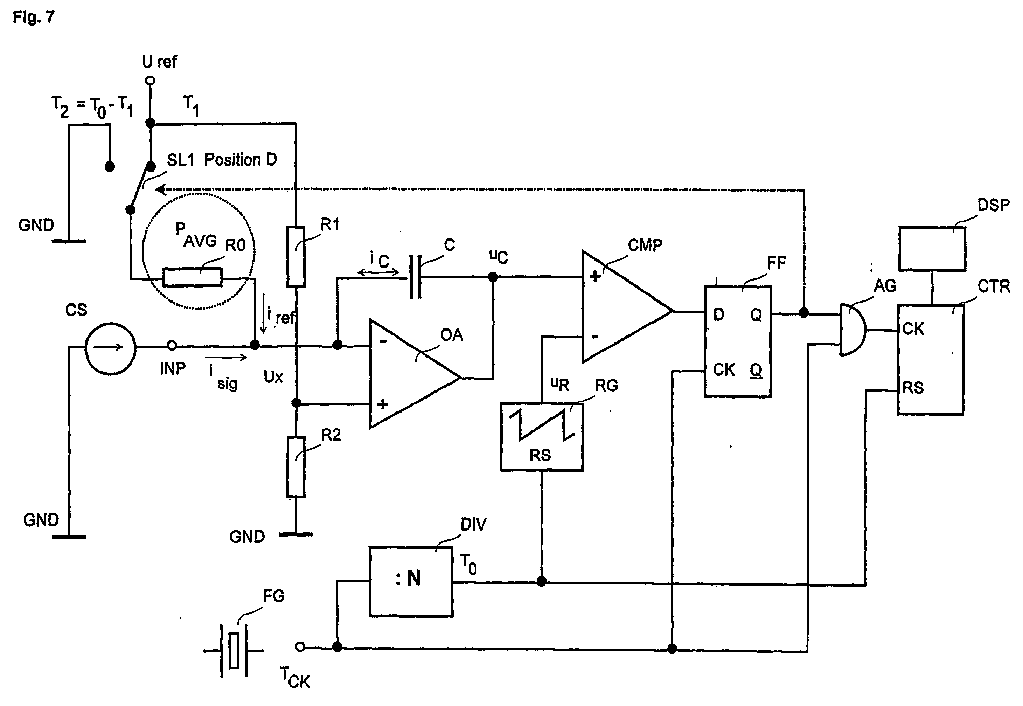

Fig. 7    einen integrierenden A/D-Wandler, dessen Eingang mit einer Stromquelle verbunden ist.

Der in Figur 1 gezeigte integrierende A/D-Wandler wurde einleitend anhand der in Figur 2 und Figur 3 gezeigten Signalverläufe bereits beschrieben.

Dieser A/D-Wandler weist einen aus einem Operationsverstärker OA und einem Kondensator C gebildeten Integrator INT auf, der mit einem nachfolgenden Komparator CMP verbunden ist, durch den die Ausgangsspannung $u_C$ des Integrators INT mit der Ausgangsspannung $u_R$ eines Rampengenerators RG verglichen wird, welch letztere periodisch, innerhalb einer Periodendauer T0, einen Spannungsbereich durchläuft. Sobald die ansteigende Ausgangsspannung $u_R$ des Rampengenerators RG die Ausgangsspannung $u_C$ des Integrators INT kreuzt und übersteigt, setzt der Komparator CMP die nachgeschaltete Kippstufe FF zurück, die erst wieder gesetzt wird, wenn die Ausgangsspannung $u_R$ des Rampengenerators RG zu Beginn einer neuen Arbeitsperiode T0 wieder auf den Anfangswert zurückfällt. Voraussetzung hierzu ist ein steilerer Rampenanstieg von $u_R$ im Vergleich zum steilstmöglichen Anstieg von $u_C$.

Mit dem Umschalten der Kippstufe FF wird die Arbeitsperiode T0 des A/D-Wandlers in zwei Anteile zerlegt. Im ersten Periodenanteil T1 ist die Kippstufe FF gesetzt und im zweiten Periodenanteil T2 ist die Kippstufe FF zurückgesetzt. Innerhalb des ersten Periodenanteils T1 wird die vom Eingangssignal $u_{sig}$ während des zweiten Periodenanteils T2 verursachte Änderung der Ladung des Kondensators C mittels eines dem Integrator INT über einen Referenzwiderstand R0 zugeführten Stromes kompensiert. Wie in Figur 2 und Figur 3 gezeigt, dauert es jeweils mehrere Arbeitsperioden T0 bis die dem Kondensator C innerhalb der beiden Periodenanteile T1, T2 zugeführten und entnommenen Ladungen balanciert sind.

Die Länge des ersten Periodenanteils T1 bzw. die innerhalb des ersten Periodenanteils T1 verstreichende Anzahl Takte $T_{CK}$, während der die durch das Eingangssignal $u_{sig}$ verursachte Ladungsänderung kompensiert wird, ist ein Mass für die Grösse des Eingangssignals $u_{sig}$. Wie einleitend beschrieben, wird ein Ausgangssignal der Kippstufe FF daher einem Zähler CTR zugeführt, welcher für jede Arbeitsperiode T0 die innerhalb des ersten Periodenanteils T1 auftretenden Takte $T_{CK}$ zählt, die von einem Taktgenerator FG erzeugt werden. Die Anzahl der innerhalb des ersten Periodenanteils T1 gezählten Takte $T_{CK}$ oder eine dazu korrespondierende Zahl kann anschliessend auf einer Anzeigeeinheit angezeigt werden.

Selbstverständlich ist es ohne weiteres möglich, die Zählung der Takte auf andere Weise vorzunehmen und das Verhältnis der Periodenanteile zur Arbeitsperiode zu ermitteln und, allenfalls nach entsprechender Umrechnung, darzustellen. Die Erfindung ist also nicht auf die Bestimmung der Anzahl der Takte des ersten Periodenanteils T1 als repräsentative Angabe für das Eingangssignal beschränkt.

In den Figuren 4, 5, 6 und 7 sind erfindungsgemässe integrierende A/D-Wandler gezeigt, die zur Verarbeitung bipolarer Eingangssignale, von Signalspannungen oder Signalströmen, geeignet sind. Die erfindungsgemässen Massnahmen betreffen den frontseitigen Aufbau der integrierenden A/D-Wandler. Die dem Integrator INT bzw. dem darin vorgesehenen Operationsverstärker OA nachgeschalteten Einheiten entsprechen im Aufbau und der Funktionalität denjenigen des A/D-Wandlers von Figur 1. Diese Schaltungseinheiten werden nachstehend daher nicht mehr im Detail besprochen.

Die erfindungsgemässen Massnahmen sind daher nicht nur in den in Figur 4, 5 und 6 beispielsweise dargestellten, sondern, gegebenenfalls mit fachmännischen Anpassungen, bei anderen integrierenden A/D-Wandlern einsetzbar, in denen innerhalb von zwei Zeitbereichen, beispielsweise innerhalb von zwei Anteilen T1, T2 eines vorzugsweise periodischen Zeitintervalls T0, ein Eingangssignal mit einem Referenzsignal verglichen wird.

Der in Fig. 4 gezeigte, erfindungsgemässe, integrierende A/D-Wandler ist zur Verarbeitung bipolarer Eingangssignale geeignet. Dazu ist der nicht-invertierende Eingang des Operationsverstärkers OA, dessen invertierender Eingang mit dem Eingangs- und dem Referenzwiderstand $R_{in}$, R0 verbunden ist, über einen ersten Widerstand R1 an die Referenzspannung $U_{ref}$ und über einen zweiten Widerstand R2 an Erdpotential GND angeschlossen. Der nicht-invertierende Eingang des als Integrator beschalteten Operationsverstärkers OA ist somit an eine Spannung

$$U_x = U_{ref} * a = U_{ref} * R2/ (R1+R2)$$

angeschlossen, die zwischen Erdpotential GND und der Referenzspannung $U_{ref}$ liegt. Durch Zuführung positiver oder negativer Eingangssignale $u_{sig}$ bezüglich dieses Potentials $U_x$ sowie durch Verbinden des Referenzwiderstandes R0 mittels des Schalters SL1 mit der Referenzspannung $U_{ref}$ oder mit Erdpotential GND kann der Kondensator C daher mit positiver oder negativer Polarität geladen und auch wieder entladen werden. Ladungsänderungen, die durch ein Eingangssignal $u_{sig}$ beliebiger Polarität verursacht werden, können daher, nach entsprechendem Betätigen des Schalters SL1, durch Zufuhr von Strömen $i_{ref}$ über den Referenzwiderstand R0 kompensiert werden. Da der Schalter SL1 den Referenzwiderstand R0 stets mit der Referenzspannung $U_{ref}$ oder mit Erdpotential GND verbindet, erfolgt durchgehend eine Überlagerung der Ströme $i_{in}$ und $i_{ref}$ im Eingangs- und im Referenzwiderstand $R_{in}$, R0. Der resultierende Strom $i_C$ im Kondensator C wird daher durch die Summe der Ströme $i_{in}$ und $i_{ref}$ gebildet. Während des ersten Periodenanteils T1 erfolgt daher die Ladungsänderung T1*($i_{in}$ + $i_{ref1}$), mittels der die während des zweiten Periodenanteils T2 erfolgte Ladungsänderung T2*($i_{in}$ + $i_{ref2}$) kompensiert wird. Die Beträge der Ströme $i_{ref1}$ und $i_{ref2}$ sind dabei gleich gross, sofern die Widerstände R1 und R2 gleich sind. Die Länge des Periodenanteils T1 bzw. die Anzahl Takte $T_{CK}$ innerhalb des Periodenanteils T1 ist daher wiederum ein Mass für die Grösse des Eingangssignals $u_{sig}$.

Gleichzeitig mit der Erweiterung des Bereichs, in dem nun bipolare bzw. positive und negative Eingangssignale $u_{sig}$ verarbeitet werden können, erfolgt erfindungsgemäss eine Stabilisierung der vom Referenzwiderstand R0 abgegebenen Verlustleistung, die vom Grössenverhältnis des ersten und zweiten Widerstandes R1, R2 abhängig ist.

Idealerweise soll die mittlere Verlustleistung im Referenzwiderstand R0 unabhängig von der Grösse und Polarität des Eingangssignals $u_{sig}$ konstant sein.

Die im Referenzwiderstand R0 abgegebenen Verlustleistungen $P_{T1}$, $P_{T2}$ sowie die entsprechenden Energien $E_{T1}$, $E_{T2}$ während des ersten und zweiten Periodenanteils T1, T2 betragen:

$$P_{T1} = (U_{ref} - U_x)^2 / R0, \qquad E_{T1} = P_{T1} * T1$$

$$P_{T2} = (0 - U_x)^2 / R0, \qquad E_{T2} = P_{T2} * T2 = P_{T2} * (T0 - T1)$$

Die durchschnittlich vom Referenzwiderstand R0 abgegebene Verlustleistung $P_{AVG}$ beträgt daher:

$$P_{AVG} = (E_{T1} + E_{T2}) / (T1+T2) = (E_{T1} + E_{T2}) / (T0)$$

$$P_{AVG} = [T1 * (U_{ref} - U_x)^2/R0] + [(T0-T1) * U_x^2 /R0)]/[T0]$$

$$P_{AVG} = [T1 * (U_{ref} - U_x)^2] + [(T0-T1) * U_x^2]/[T0*R0]$$

$$P_{AVG} = [T1 * (U_{ref}^2 - 2 U_{ref} U_x + U_x^2)] + [(T0-T1) * U_x^2] / [T0*R0]$$

$$P_{AVG} = [T1 U_{ref}^2 - 2 T1 U_{ref} U_x + T1 U_x^2 - T1 U_x^2 + T0 U_x^2] / [T0*R0]$$

$$P_{AVG} = [T1 (U_{ref}^2-2 U_{ref} U_x) + T0 * U_x^2] / [T0 * R0]$$

Für $U_x = a * U_{ref}$ und T1 = D * T0 gilt:

$$P_{AVG} = [D*T0 (U_{ref}^2-2a U_{ref}^2) + T0 a^2 U_{ref}^2] / [T0*R0]$$

$$P_{AVG} = [U_{ref}^2 / R0] * [D (1-2a) + a^2]$$

Aus der letzten Formel ist ersichtlich, dass die Verlustleistung $P_{AVG}$ dann vom Tastverhältnis D = T1 / T0 unabhängig und konstant ist, wenn der Ausdruck (1-2a) den Wert Null annimmt. Bei a = 1/2 lautet die Formel für die mittlere Verlustleistung daher

$$P_{AVG} = [U_{ref}^2 / R0] * [a^2] = const$$

Sofern a = 1/2 = $U_x$ / $U_{ref}$ = R2 / (R1 + R2) und somit R1 = R2 ist, bleibt die Verlustleistung $P_{AVG}$ im Referenzwiderstand R0, unabhängig vom Eingangssignal $u_{sig}$ und dem daraus resultierenden Tastverhältnis D, stets konstant.

Idealerweise werden die Grössen der Widerstände R1 und R2 daher gleich gewählt. Unter Berücksichtigung der tolerierbaren Änderungen des Referenzwiderstandes R0 können in der Schaltungsanordnung von Figur 4 jedoch auch unterschiedliche Werte für die Widerstände R1 und R2 und somit auch unterschiedliche Bereiche zu verarbeitender Eingangssignale $u_{sig}$ gewählt werden.

Figur 5 zeigt einen stabilisierten integrierenden A/D-Wandler mit beliebig wählbarem Arbeitsbereich für die Verarbeitung bipolarer Eingangssignale. Bei diesem erfindungsgemässen A/D-Wandler sind zwei Referenzteilwiderstände R01 und R02 vorgesehen, die einerseits mit dem invertierenden Eingang des Operationsverstärkers OA verbunden sind und von denen, mittels eines Schalters SL2, der erste Referenzteilwiderstand R01 während des ersten Periodenanteils T1 mit der Referenzspannung $U_{ref}$ und während des zweiten Periodenanteils T2 mit Erdpotential GND und von denen der zweite Referenzteilwiderstand R02 während des ersten Periodenanteils T1 mit Erdpotential GND und während des zweiten Periodenanteils T2 mit der Referenzspannung $U_{ref}$ verbunden ist. Dabei gilt es zu beachten, dass die beiden Widerstände nicht gleich gross sein dürfen. Das Verhältnis von R01 zu R02 ist mit bestimmend für den Bereich in dem das Tastverhältnis D = T1/T0 liegen kann, damit der Regeldurchgriff noch gewährleistet ist. Die Verlustleistungen $P_{AVG1}$ und $P_{AVG2}$ in den Referenzteilwiderständen R01 und R02 lauten daher wie folgt:

$$P_{AVG1} = [U_{ref}^2 / R01] * [D (1-2a) + a^2]$$

$$P_{AVG2} = [U_{ref}^2 / R02] * [(1-D) (1-2a) + a^2]$$

Die Summe dieser beiden Verlustleistungen

$$P_{AVG12} = P_{AVG1} + P_{AVG2}$$

bleibt, unabhängig von der Grösse der angelegten Eingangssignale $u_{sig}$, konstant, sofern a = 1/2 gewählt wird. In diesem Fall (R1=R2), bei dem wiederum

$$a = 1/2 = U_x / U_{ref} = R2 / (R1 + R2)$$

ist, gilt folgendes:

$$P_{AVG12} = [U_{ref}^2 / R01] * 1/4 + [U_{ref}^2 / R02] * 1/4$$

$$P_{AVG12} = U_{ref}^2 /4 (1/R01 + 1/R02)$$

Die Verlustleistungssumme $P_{AVG12}$ ist bei a = 1/2 daher unabhängig von der Grösse der angelegten Eingangssignale $u_{sig}$ und der Werte der beiden Referenzteilwiderstände R01, R02, stets konstant.

Sofern die Verlustleistungssumme $P_{AVG12}$ konstant gehalten wird und die Referenzteilwiderstände R01 und R02 thermisch gekoppelt sind, weisen diese daher unabhängig von den Eingangssignalen $u_{sig}$ stets zumindest annähernd dieselbe Temperatur auf, wodurch Fehler bei der Signalverarbeitung vermieden werden. Eine gute thermische Kopplung kann beispielsweise erzielt werden, indem Referenzteilwiderstände R01 und R02 verwendet werden, welche monolithisch gefertigt und/oder in einem gemeinsamen Gehäuse integriert sind.

Sofern a ≠ 1/2 gewählt wird, erfolgt eine weitgehende Stabilisierung der Verlustleistungssumme $P_{AVG12}$ indem die Werte der beiden Referenzteilwiderstände R01, R02 einander angenähert werden. Dabei gilt es abzuwägen zwischen den sich gegenseitig ausschliessenden Zielen einer möglichst konstanten Verlustleistungssumme durch möglichst gleiche Werte der Referenzteilwiderstände einerseits und dem möglichst grossen Bereich für das Tastverhältnis D, mit dem eine Konvergenz der Ladungsbilanz noch gewährleistet ist, durch möglichst unterschiedliche Werte der Referenzteilwiderstände.

Die Referenz- bzw. Referenzteilwiderstände R0 bzw. R01, R02 der in Figur 4 und Figur 5 gezeigten A/D-Wandler weisen daher, unter Berücksichtigung der beschriebenen Rahmenbedingungen, unabhängig von den Eingangssignalen $u_{sig}$ stets zumindest annähernd die gleiche Verlustleistung und somit auch das gleiche Betriebsverhalten auf. Eine aufwendige externe Temperaturstabilisierung wird daher nicht benötigt. Fehler bei der A/D Wandlung der Eingangssignale $u_{sig}$ werden erfindungsgemäss daher mit kostengünstigen Massnahmen wirkungsvoll vermieden.

Figur 6 zeigt den stabilisierten integrierenden A/D-Wandler von Figur 4 in einer vorzugsweisen Ausgestaltung, in der möglicherweise zwischen $U_{ref}$ und GND über den Schalter fliessende Kurzschlussströme während des Betriebs vermieden werden. Derartige Kurzschlussströme könnten auftreten, wenn eine Schalterkombination SW1/SW2 nach Fig. 1 oder ein Umschalter SL1 oder SL2 nach Fig. 4 oder Fig. 5 nicht klaglos nach dem Prinzip "brake before make" funktioniert. Wie in Figur 6 gezeigt, sind zwischen den Schaltkontakten des Schalters SL3, die an Erdpotential GND bzw. an die Betriebsspannung $U_{ref}$ angeschlossen sind, zwei geschaltete Verbindungselemente vorgesehen, von denen das erste mit einem ersten Referenzwiderstand R03 und das zweite mit einem zweiten Referenzwiderstand R04 verbunden ist. Durch diese Schaltungsanordnung wird gewährleistet, dass keine Kurzschlussströme von der Betriebsspannung $U_{ref}$ auf Erdpotential GND fliessen können.

Die Referenzwiderstände R03, R04 sind einerseits mit dem invertierenden Eingang des Operationsverstärkers OA verbunden. Andererseits ist der erste Referenzwiderstand R03 mittels des Schalters SL3 während des ersten Periodenanteils T1 mit der Referenzspannung $U_{ref}$ und der zweite Referenzwiderstand R04 während des zweiten Periodenanteils T2 mit Erdpotential GND verbindbar.

Sofern a = 1/2 = $U_x$ / $U_{ref}$ = R2 / (R1 + R2) und somit R1 = R2 ist und zudem die Werte der Referenzwiderstände R03, R04 gleich sind (R03 = R04 = RX), bleibt die Summe $P_{AVG34}$ der Verlustleistungen in den Referenzwiderständen R03, R04, unabhängig vom Eingangssignal $u_{sig}$ und dem daraus resultierenden Tastverhältnis D, stets konstant.

Die Verlustleistungen $P_{AVG3}$ und $P_{AVG4}$ in den Referenzwiderständen R03 und R04 lauten unter Berücksichtigung dieser beiden Bedingungen (R1 = R2 und R03 = R04 = RX) wie folgt:

$$P_{AVG3} = [U_{ref}^{2} * a^{2} / RX] * D$$

$$P_{AVG4} = [U_{ref}^{2} (1-a)^{2} / RX] * (1-D)$$

Die Verlustleistungssumme bei a = 1/2

$$P_{AVG34} = P_{AVG3} + P_{AVG4} = [U_{ref}^{2} / 4 RX] * D + [U_{ref}^{2} / 4 RX] * (1-D)$$

$$P_{AVG34} = [U_{ref}^{2} / 4 RX] [D + (1-D)] = [U_{ref}^{2} / 4 RX]$$

ist daher unabhängig vom Tastverhältnis D und somit auch vom Eingangssignal $u_{sig}$. Sofern die Verlustleistungssumme $P_{AVG34}$ konstant gehalten wird und die Referenzwiderstände R03 und R04 thermisch gekoppelt sind, weisen diese daher unabhängig von den Eingangssignalen $u_{sig}$ stets zumindest annähernd dieselbe Temperatur auf, weshalb auf eine externe Temperaturstabilisierung verzichtet werden kann.

Figur 7 zeigt den integrierenden A/D-Wandler von Figur 4 in einer vorzugsweisen Ausgestaltung. In der Schaltungsanordnung von Figur 4 wird eine gegebenenfalls bipolare Signalspannung $u_{sig}$ über einen Eingangswiderstand Rin an den invertierenden Eingang des Operationsverstärkers OA angelegt. In der Schaltungsanordnung von Figur 7 ist der invertierende Eingang des Operationsverstärkers OA hingegen direkt mit einer Stromquelle CS verbunden, deren Strom $i_{sig}$, unabhängig von der Flussrichtung, gemessen und digital dargestellt werden kann. Die Stromquelle CS ist in gleicher Weise an die in Figur 5 und 6 gezeigten integrierenden A/D-Wandler anschliessbar.

Literaturverzeichnis:

**EP 1 400 020 B1**

[1] Europäische Patentanmeldung EP 0 990 880 A2

[2] Richard C. Dorf, Electrical Engineering Handbook, zweite Ausgabe, CRC Press, Boca Raton 1997

[3] USA Patent 4,164,733

**Patentansprüche**

1. Integrierender A/D-Wandler mit einem Operationsverstärker (OA), dessen Ausgang und dessen invertierender Eingang über einen Kondensator (C) miteinander verbunden sind, welchem über einen Signaleingang (INP) und einen an eine Referenzspannung $U_{ref}$ angeschlossenen Referenzwiderstand (R0) während eines ersten Periodenanteils (T1) und eines zweiten Periodenanteils (T2) einer Arbeitsperiode (T0) Ladungen zuführbar und wieder entnehmbar sind, die durch Änderung der Periodenanteile (T1, T2) balancierbar sind, so dass im zeitlichen Mittel die innerhalb des einen der Periodenanteile verstreichende Anzahl Takte eines Taktsignals ($T_{CK}$) ein digital darstellbares Mass für die Grösse des an den Signaleingang (INP) angelegten Eingangssignals ($u_{sig}$, $i_{sig}$) ist, wobei der nicht-invertierende Eingang des Operationsverstärkers (OA) über einen ersten Widerstand (R1) mit der Referenzspannung $U_{ref}$ und über einen zweiten Widerstand (R2) mit Erdpotential (GND) verbunden ist, der eine Anschluss des Referenzwiderstands (R0) mittels eines Schalters (SL1) während des einen Periodenanteils mit der Referenzspannung $U_{ref}$ und während des anderen Periodenanteils mit Erdpotential (GND) verbindbar ist und der andere Anschluss des Referenzwiderstands (R0) direkt mit dem invertierenden Eingang des Operationsverstärkers (OA) verbunden ist.

2. Integrierender A/D-Wandler nach Anspruch 1, **dadurch gekennzeichnet, dass** der erste und der zweite Widerstand (R1, R2) zumindest annähernd den gleichen Widerstandswert aufweisen.

3. Integrierender A/D-Wandler nach Anspruch 1 oder 2, **dadurch gekennzeichnet, dass** der Referenzwiderstand (R0) in zwei Referenzteilwiderstände (R01, R02) aufgeteilt ist, die einerseits mit dem invertierenden Eingang des Operationsverstärkers (OA) verbunden sind und von denen mittels eines Schalters (SL2) der erste Referenzteilwiderstand (R01) während des ersten Periodenanteils (T1) mit der Referenzspannung ($U_{ref}$) und während des zweiten Periodenanteils (T2) mit Erdpotential (GND) und von denen der zweite Referenzteilwiderstand (R02) während des ersten Periodenanteils (T1) mit Erdpotential (GND) und während des zweiten Periodenanteils (T2) mit der Referenzspannung ($U_{ref}$) verbindbar ist.

4. Integrierender A/D-Wandler nach Anspruch 1 oder 2, **dadurch gekennzeichnet, dass** zwei Referenzwiderstände (R03, R04) vorgesehen sind, die einerseits mit dem invertierenden Eingang des Operationsverstärkers (OA) verbunden sind und von denen andererseits mittels eines Schalters (SL3) der erste Referenzwiderstand (R03) während des ersten Periodenanteils (T1) mit der Referenzspannung ($U_{ref}$) und der zweite Referenzwiderstand (R04) während des zweiten Periodenanteils (T2) mit Erdpotential (GND) verbindbar ist.

5. Integrierender A/D-Wandler nach Anspruch 4, **dadurch gekennzeichnet, dass** der erste und der zweite Referenzwiderstand (R03, R04) zumindest annähernd den gleichen Widerstandswert aufweisen.

6. Integrierender A/D-Wandler nach einem der Ansprüche 3 bis 5, **dadurch gekennzeichnet, dass** die Referenzteilwiderstände (R01, R02) oder die Referenzwiderstände (R03, R04) thermisch gekoppelt, monolithisch gefertigt und/oder in einem gemeinsamen Gehäuse angeordnet sind.

7. Integrierender A/D-Wandler nach einem der Ansprüche 1 bis 6, **dadurch gekennzeichnet, dass** der Ausgang des Operationsverstärkers (OA) mit dem nicht-invertierenden Eingang eines Komparators (CMP) verbunden ist, dessen invertierendem Eingang eine eine bestimmte Periodendauer (T0) aufweisende Ausgangsspannung ($u_R$) eines Rampengenerators (RG) zuführbar ist und dessen Ausgang mit dem Signaleingang einer Kippstufe (FF) verbunden ist, dessen Ausgangssignale (Q, $\underline{Q}$) zur Steuerung des Schalters (SL1; SL2; SL3) dienen.

8. Integrierender A/D-Wandler nach Anspruch 7, **dadurch gekennzeichnet, dass** einem Zähler (CTR) ein einen ersten Periodenanteil (T1) anzeigendes Ausgangssignal (Q) der Kippstufe (FF), Taktsignale ($T_{CK}$) sowie durch Teilung von den Taktsignalen ($T_{CK}$) abgeleitete Taktsignale der bestimmten Periodendauer (T0) derart zuführbar sind, dass der Zähler (CTR) während jeder Periodendauer (T0) die Anzahl der innerhalb des ersten Periodenanteils (T1) auftretenden Taktsignale zählen kann, die der Grösse des Eingangssignals ($u_{sig}$) entspricht.

9. Integrierender A/D-Wandler nach einem der Ansprüche 1 bis 8, **dadurch gekennzeichnet, dass** der Signaleingang (INP), an den eine gegebenenfalls bipolare Signalspannung ($u_{sig}$) angelegt ist, über einen Eingangswiderstand ($R_{in}$) mit dem invertierenden Eingang des Operationsverstärkers (OA) verbunden ist.

10. Integrierender A/D-Wandler nach einem der Ansprüche 1 bis 8, **dadurch gekennzeichnet, dass** der Signaleingang (INP), dem ein gegebenenfalls bipolarer Signalstrom ($i_{sig}$) aufgeprägt wird, direkt mit dem invertierenden Eingang des Operationsverstärkers (OA) verbunden ist.

11. Integrierender A/D-Wandler nach Anspruch 10, **dadurch gekennzeichnet, dass** eine Stromquelle (CS) mit dem Signaleingang (INP) verbunden ist, die Teil einer Kraftmessvorrichtung, gegebenenfalls einer Waage, ist.

**Claims**

1. An integrating A/D converter with an operational amplifier (OA), the output and the inverting input of which are interconnected by means of a capacitor (C), wherein charges can be supplied to and withdrawn from said capacitor during a first period segment (T1) and a second period segment (T2) of a working period (T0) via a signal input (INP) and a reference resistor (R0) that is connected to a reference voltage $U_{ref}$, wherein said charges can be balanced by changing the period segments (T1, T2) such that, on average, the number of clock pulses of a clock pulse signal ($T_{CK}$) elapsing within one of the period segments represents a quantity for the magnitude of the input signal ($u_{sig}$, $i_{sig}$) applied to the signal input (INP) and can be output in digital form, wherein the non-inverting input of the operational amplifier (OA) is connected to the reference voltage $U_{ref}$ via a first resistor (R1) and to the ground potential (GND) via a second resistor (R2), wherein a switch (SL1) connects one terminal of the reference resistor (R0) to the reference voltage $U_{ref}$ during one period segment and to the ground potential (GND) during the other period segment, and wherein the other terminal of the reference resistor (R0) is directly connected to the inverting input of the operational amplifier (OA).

2. The integrating A/D converter according to Claim 1, **characterized in that** the first and the second resistor (R1, R2) have at least approximately the same resistance value.

3. The integrating A/D converter according to Claim 1 or 2, **characterized in that** the reference resistor (R0) is divided into two partial reference resistors (R01, R01) that are connected to the inverting input of the operational amplifier (OA), wherein a switch (SL2) connects the first partial reference resistor (R01) to the reference voltage ($U_{ref}$) during the first period segment (T1) and to the ground potential (GND) during the second period segment (T2) and the second partial reference resistor (R02) to the ground potential (GND) during the first period segment (T1) and to the reference voltage ($U_{ref}$) during the second period segment (T2).

4. The integrating A/D converter according to Claim 1 or 2, **characterized in that** two reference resistors (R03, R04) are provided and connected to the inverting input of the operational amplifier (OA), wherein a switch (SL3) connects the first reference resistor (R03) to the reference voltage ($U_{ref}$) during the first period segment (T1) and the second reference resistor (R04) to the ground potential (GND) during the second period segment (T2).

5. The integrating A/D converter according to Claim 4, **characterized in that** the first and the second reference resistor (R03, R04) have an at least approximately identical resistance value.

6. The integrating A/D converter according to one of Claims 3-5, **characterized in that** the partial reference resistors (R01, R02) or the reference resistors (R03, R04) are thermally coupled, manufactured in a monolithic fashion and/or arranged in a common housing.

7. The integrating A/D converter according to one of Claims 1-6, **characterized in that** the output of the operational amplifier (OA) is connected to the non-inverting input of a comparator (CMP), the inverting input of which can be supplied with the output voltage ($u_R$) of a ramp generator (RG) whereas the output voltage ($u_R$) has a certain period (T0), the output of the comparator (CMP) is connected to the signal input of a flip-flop (FF) and the output signals (Q, $\overline{Q}$) of the flip-flop (FF) serve for controlling the switch (SL1; SL2; SL3).

8. The integrating A/D converter according to Claim 7, **characterized in that** an output signal (Q) of the flip-flop (FF) that indicates a first period segment (T1), clock signals ($T_{CK}$) as well as clock signals of the certain period (T0) obtained by dividing the clock signals ($T_{CK}$) can be supplied to a counter (CTR) in such a way that the counter (CTR) is able to count the clock signals that elapse within the first period segment (T1) whereas this number of counts corresponds to the magnitude of the input signal ($u_{sig}$) during each period (T0).

9. The integrating A/D converter according to one of Claims 1-8, **characterized in that** the signal input (INP), to which, if applicable, a bipolar signal voltage ($i_{sig}$) is applied, is connected to the inverting input of the operational amplifier (OA) via an input resistor ($R_{in}$).

10. The integrating A/D converter according to one of Claims 1-8, **characterized in that** the signal input (INP), to which, if applicable, a bipolar signal voltage ($i_{sig}$) is applied, is directly connected to the inverting input of the operational amplifier (OA).

11. The integrating A/D converter according to Claim 10, **characterized in that** a current source (CS), which is connected to the signal input (INP), forms part of a force-sensing device, if applicable, a balance.

**Revendications**

1. Convertisseur analogique/numérique intégrant comprenant un amplificateur opérationnel (OA), dont la sortie et dont l'entrée inversante sont reliées entre elles au moyen d'un condensateur (C), auquel des charges peuvent être amenées et de nouveau enlevées au moyen d'une entrée de signal (INP) et d'une résistance de référence (R0) raccordée à une tension de référence $U_{ref}$ pendant une première fraction de période (T1) et d'une seconde fraction de période (T2) d'une période de travail (T0), lesquelles charges peuvent être équilibrées par la variation des fractions de période (T1, T2), de sorte que, en moyenne dans le temps, le nombre de rythmes d'un signal de rythme ($T_{CK}$) qui s'écoule pendant l'une des fractions de période est une référence pouvant être présentée de façon numérique pour la grandeur du signal d'entrée ($u_{sig}$, $i_{sig}$) appliqué à l'entrée du signal (INP), l'entrée non inversante de l'amplificateur opérationnel (OA) étant reliée par une première résistance (R1) à la tension de référence $U_{ref}$ et par une seconde résistance (R2) au potentiel terrestre (GND), l'un des branchements de la résistance de référence (R0) pouvant être relié à la tension de référence $U_{ref}$ au moyen d'un interrupteur (SL1) pendant une fraction de période et à du potentiel terrestre (GND) pendant l'autre fraction de période et l'autre branchement de la résistance de référence (R0) étant relié directement à l'entrée inversante de l'amplificateur opérationnel (OA).

2. Convertisseur analogique/numérique intégrant selon la revendication 1, **caractérisé en ce que** la première et la seconde résistances (R1, R2) présentent au moins approximativement la même valeur de résistance.

3. Convertisseur analogique/numérique intégrant selon la revendication 1 ou 2, **caractérisé en ce que** la résistance de référence (R0) est subdivisée en deux résistances partielles de référence (R01, R02), qui sont reliées d'une part à l'entrée inversante de l'amplificateur opérationnel (OA) et dont la première résistance partielle de référence (R01) est reliée à la tension de référence ($U_{ref}$) pendant la première fraction de période (T1) et à du potentiel terrestre (GND) pendant la seconde fraction de période (T2) au moyen d'un interrupteur (SL2) et dont la seconde résistance partielle de référence (R02) peut être reliée à du potentiel terrestre (GND) pendant la première fraction de période (T1) et à la tension de référence ($U_{ref}$) pendant la seconde fraction de période (T2).

4. Convertisseur analogique/numérique intégrant selon la revendication 1 ou 2 **caractérisé en ce qu'**il est prévu deux résistances de référence (R03, R04), qui sont reliées d'une part à l'entrée inversante de l'amplificateur opérationnel (OA) et dont d'autre part la première résistance de référence (R03) peut être reliée au moyen d'un interrupteur (SL3) à la tension de référence ($U_{ref}$) pendant la première fraction de période (T1) et la seconde résistance de référence (R04) peut être reliée au moyen d'un interrupteur (SL3) du potentiel terrestre (GND) pendant la seconde fraction de période (T2).

5. Convertisseur analogique/numérique intégrant selon la revendication 4, **caractérisé en ce que** la première et la seconde résistances de référence (R03, R04) présentent au moins approximativement la même valeur de résistance.

6. Convertisseur analogique/numérique intégrant selon l'une quelconque des revendications 3 à 5, **caractérisé en ce que** les résistances partielles de référence (R01, R02) ou les résistances de référence (R03, R04) sont couplées thermiquement, fabriquées de façon monolithe et/ou disposées dans un boîtier commun.

7. Convertisseur analogique/numérique intégrant selon l'une quelconque des revendications 1 à 6, **caractérisé en ce que** la sortie de l'amplificateur opérationnel (OA) est reliée à l'entrée non inversante d'un comparateur (CMP), à l'entrée inversante du comparateur (CMP) peut être amenée une tension de sortie (u<sub>R</sub>) présentant une durée de période (T0) définie d'un générateur de rampe (RG), et que la sortie de comparateur (CMP) est reliée au signal d'entrée d'un niveau à bascule (FF), et que les signaux de sortie (Q, Q̲) de niveau à bascule (FF) servent à la commande de l'interrupteur (SL1 ; SL2 ; SL3).

**8.** Convertisseur analogique/numérique intégrant selon la revendication 7, **caractérisé en ce qu'**un signal de sortie (Q), indiquant une première fraction de période (T1), du niveau à bascule (FF), des signaux de rythme (T$_{CK}$) et des signaux de rythme, déduits par division des signaux de rythme (T$_{CK}$), de la durée de période (T0) définie peuvent être amenés à un compteur (CTR) de telle sorte que le compteur (CTR) peut compter pendant chaque durée de période (T0) le nombre des signaux de rythme apparaissant à l'intérieur de la première fraction de période (T1), qui correspond à la grandeur du signal d'entrée (u$_{sig}$).

**9.** Convertisseur analogique/numérique intégrant selon l'une quelconque des revendications 1 à 8, **caractérisé en ce que** l'entrée de signal (INP), sur laquelle est appliquée une tension de signal (u$_{sig}$) éventuellement bipolaire, est reliée au moyen d'une résistance d'entrée (R$_{in}$) à l'entrée inversante de l'amplificateur opérationnel (OA).

**10.** Convertisseur analogique/numérique intégrant selon l'une quelconque des revendications 1 à 8, **caractérisé en ce que** l'entrée de signal (INP), à laquelle est appliqué un courant de signal (i$_{sig}$) éventuellement bipolaire, est reliée directement à l'entrée inversante de l'amplificateur opérationnel (OA).

**11.** Convertisseur analogique/numérique intégrant selon la revendication 10, **caractérisé en ce qu'**une source de courant (CS) est reliée à l'entrée de signal (INP), qui fait partie d'un dispositif de mesure de force, éventuellement d'une balance.

Fig. 1

Fig. 2a

Fig. 2b

Fig. 2c

Fig. 2d

EP 1 400 020 B1

Fig. 4

**Fig. 5**

EP 1 400 020 B1

Fig. 6

Fig. 7